Europäisches Patentamt

European Patent Office

Office européen des brevets

(19)

(11) Veröffentlichungsnummer: **0 427 069 A2**

# (12) EUROPÄISCHE PATENTANMELDUNG

(21) Anmeldenummer: 90120638.3

(22) Anmeldetag: 27.10.90

(51) Int. Cl.⁵: **C11D 7/50**

(30) Priorität: 06.11.89 DE 3936887
31.05.90 DE 4017492

(43) Veröffentlichungstag der Anmeldung:
15.05.91 Patentblatt 91/20

(84) Benannte Vertragsstaaten:
AT BE CH DE DK ES FR GB GR IT LI LU NL SE

(71) Anmelder: **Kali-Chemie Aktiengesellschaft**
**Postfach 220, Hans-Böckler-Allee 20**
**W-3000 Hannover 1(DE)**

(72) Erfinder: **Buchwald, Hans**
**Am Rodelberg 51 A**
**W-3003 Ronnenberg(DE)**
Erfinder: **Brackmann, Andreas**
**Hedwigstrasse 10**
**W-3000 Hannover 1(DE)**
Erfinder: **Raszkowski, Boleslaus**
**In der Hespe 246**
**W-3061 Wiedensahl(DE)**

(74) Vertreter: **Lauer, Dieter, Dr.**
**c/o Kali-Chemie Aktiengesellschaft Postfach**
**220**
**W-3000 Hannover 1(DE)**

(54) **Reinigungszusammensetzungen aus wasserstoffhaltigen Fluorchlorkohlenwasserstoffen und partiell fluorierten Alkanolen.**

(57) Beschrieben werden neue Zusammensetzungen auf Basis von wasserstoffhaltigen Fluorchlorkohlenrnasserstoffen aus der Gruppe der Tetrachlormonofluorethane, der Trichlordifluorethane, der Dichlortrifluorethane, der Dichlormonofluorethane und Dichlorpentafluorpropane oder eines Gemisches aus diesen wasserstoffhaltigen Fluorchlorkohlenwasserstoffen im Gemisch mit teilweise fluorierten Alkanolen mit 2 bis 4 C-Atomen, die sich zur Verwendung in Reinigungsverfahren eignen.

EP 0 427 069 A2

EP 0 427 069 A2

## REINIGUNGSZUSAMMENSETZUNGEN AUS WASSERSTOFFHALTIGEN FLUORCHLORKOHLENWASSER-
## STOFFEN UND PARTIELL FLUORIERTEN ALKANOLEN

Die vorliegende Erfindung bezieht sich auf verbesserte Reinigungszusammensetzungen auf der Basis von wasserstoffhaltigen Fluorchlorkohlenwasserstoffen mit 2 bis 3 C-Atomen im Gemisch mit partiell fluorierten Alkanolen mit 2 bis 4 C-Atomen, deren Verwendung und verfahren zur Reinigung von Oberflächen von Gegenständen mit diesen Zusammensetzungen.

An Lösungsmittel für Reinigungszwecke werden sehr strenge Anforderungen gestellt. Solche Lösungsmittel sollten einen relativ niedrigen Siedepunkt aufweisen und nicht entflammbar und weitgehend untoxisch sein sowie hohes Lösevermögen für die zu entfernenden Verunreinigungen aufweisen. Diese Anforderungen lassen sich in der Regel aber nicht mit nur einem einzigen, reinen Lösungsmittel erfüllen. Daher kommen in der Praxis eine Vielzahl von Lösungsmittelgemischen mit mehr oder weniger unterschiedlichen Zusammensetzungen zur Anwendung. So ist es allgemein bekannt, für industrielle Reinigungsverfahren oder für die Dampfentfettung neben reinen chlorierten und/oder fluorierten Kohlenwasserstoffen auch Gemische von Fluorchlorkohlenwasserstoffen (als Hauptlösungsmittel) mit einem Colösungsmittel einzusetzen. Solche Gemische können sowohl nichtazeotrop als auch azeotrop bzw. azeotropartig sein. Unter azeotropartig wird dabei verstanden, daß Gemische über einen größeren Konzentrationsbereich im wesentlichen konstant sieden (Änderung der Siedetemperatur um nicht mehr als 5 °C) und sich für den praktischen Einsatz daher ähnlich wie Azeotrope verhalten.

Zwar wurden bereits viele Anstrengungen unternommen, um für verschiedene Anwendungsgebiete Reinigungszusammensetzungen mit den gewünschten Eigenschaften zu erzielen, doch sind die bekannten Gemische in ihren anwendungstechnischen, toxikologischen und die Umwelt beeinflussenden Eigenschaften immer noch verbesserungsbedürftig. So haben sich z.B. im Zusammenhang mit den technischen Weiterentwicklungen im Bereich der Flußmittel neue Anforderungen hinsichtlich der Entfernung dieser neuentwickelten Flußmittel ergeben. Diese Anforderungen werden durch die bekannten Lösungsmittelgemische nicht immer oder häufig nur unbefriedigend erfüllt. Oder andere bekannte Lösungsmittelgemische sind kompliziert zusammengesetzte Vielkomponentensysteme oder enthalten größere Anteile an toxikologisch und unter Sicherheitsaspekten (niedriger Flammpunkt) bedenklichen Lösungsmitteln. Bei wieder anderen Lösungsmittelbestandteilen ist aufgrund ihrer die Umwelt beeinflussenden Eigenschaften ein Ersatz durch andere, für die jeweiligen Anwendungszwecke mindestens gleichermaßen gut geeignete Lösungsmittel wünschenswert. Es besteht daher auch heute noch Bedarf an neuen Lösungsmittelgemischen mit neuen speziellen Eigenschaften, die darüber hinaus auch hinsichtlich der Kriterien Toxikologie und insbesondere Umweltbeeinflussung erhöhte Unbedenklichkeit aufweisen.

Es bestand daher die Aufgabe. neue Lösungsmittelgemische zur Verfügung zu stellen, die die Nachteile des Standes der Technik überwinden und zu Reinigungszwecken, insbesondere auch zur Entfernung moderner Flußmittel, besonders gut geeignet sind.

Zur Lösung dieser Aufgabe schlägt die Erfindung neue Zusammensetzungen vor, die sich durch einen Gehalt an 99,5 bis 50,0 Gew.-% eines wasserstoffhaltigen Fluor chlorkohlenwasserstoffes mit 2 bis 3 6-Atomen aus der Gruppe der Tetrachlormonofluorethane, der Trichlordifluorethane, der Dichlortrifluorethane, der Dichlormonofluorethane und Dichlorpentafluorpropane oder eines Gemisches aus diesen wasserstoffhaltigen Fluorchlorkohlenwasserstoffen und 0,5 bis 50,0 Gew.-% eines teilweise fluorierten Alkanols mit 2 bis 4 C-Atomen oder eines Gemisches dieser teilweise fluorierten Alkanole auszeichnen, wobei die Summe der Bestandteile 100 Gew.-% ist.

Tetrachlormonofluorethane im Sinne der Erfindung sind die ein Wasserstoffatom tragenden Fluorchlorkohlenwasserstoffe der Summenformel $C_2HCl_4F$. Es handelt sich also um die zwei nicht vollhalogenierten isomeren Fluorchlorkohlenwasserstoffe 1,1,1,2-Tetrachlor-2-fluorethan (R121a) und 1,1,2,2-Tetrachlor-2-fluorethan (R121).

Trichlordifluorethane im Sinne der Erfindung sind die ein Wasserstoffatom tragenden Fluorchlorkohlenwasserstoffe der Summenformel $C_2HCl_3F_2$. Es handelt sich also um die drei nicht vollhalogenierten isomeren Fluorchlorkohlenwasserstoffe 1,1,1-Trichlor-2,2-difluorethan (R122b), 1,1,2-Trichlor-2,2-difluorethan (R122) und 1,1,2-Trichlor-1,2-difluorethan (R122a).

Dichlortrifluorethane im Sinne der Erfindung sind die ein Wasserstoffatom tragenden Fluorchlorkohlenwasserstoffe der Summenformel $C_2HCl_2F_3$. Es handelt sich also um die drei nicht vollhalogenierten isomeren Fluorchlorkohlenwasserstoffe 1,1-Dichlor-2,2,2-trifluorethan (R123), 1,2-Dichlor-1,1,2-trifluorethan (R123a) und 1,1-Dichlor-1,2,2-trifluorethan (R123b).

Dichlormonofluorethane im Sinne der Erfindung sind die ein Wasserstoffatom tragenden Fluorchlorkohlenwasserstoffe der Summenformel $C_2H_3Cl_2F$. Es handelt sich also um die drei nicht vollhalogenierten

2

isomeren Fluorchlorkohlenwasserstoffe 1,2-Dichlor-1-fluorethan (R141), 1,1-Di chlor-2-fluorethan (R141a) und 1,1-Dichlor-1-fluorethan (R141b).

Dichlorpentafluorpropane im Sinne der Erfindung sind die ein Wasserstoffatom tragenden Fluorchlorkohlenwasserstoffe der Summenformel $C_3HCl_2F_5$. Es handelt sich insbesondere um die nicht vollhalogenierten isomeren Fluorchlorkohlenwasserstoffe 1,2-Dichlor-1,1,2,3,3-penta fluorpropan, 2,3-Dichlor-1,1,1,2,3-pentafluorpropan, 1,1-Dichlor-2,2,3,3,3-pentafluorpropan ( = 3,3-Dichlor-1,1,1,2,2-pentafluorpropan), 1,3-Dichlor-1,1,2,2,3-pentafluorpropan, 1,1-Dichlor-1,2,2,3,3-pentafluorpropan, 1,2-Dichlor-1,1,3,3,3-pentafluorpropan, 1,1-Dichlor-1,2,3,3,3-pentafluorpropan. Bevorzugte Dichlorpentafluorpropane sind 1,1-Dichlor-2,2,3,3,3-pentafluorpropan (R225ca) und 1,3-Dichlor-1,1,2,2,3-pentafluorpropan (R225cb).

Zweckmäßig enthalten die Zusammensetzungen insbesondere wasserstoffhaltige Fluorchlorkohlenwasserstoffe aus der Gruppe der Dichlortrifluorethane, Dichlormonofluorethane, Dichlorpentafluorpropane oder deren Gemische. Besonders bevorzugt sind Zusammensetzungen, in denen das Dichlortrifluorethan das Isomere 1,1-Dichlor-2,2,2-trifluorethan (R123) und das Dichlormonofluorethan das Isomere 1,1-Dichlor-1-fluorethan (R141b) ist oder in denen Gemische derselben enthalten sind, sowie Zusammensetzungen, in denen das Dichlorpentafluorpropan das Isomere 1,1-Dichlor-2,2,3,3,3-pentafluorpropan (R225ca) oder 1,3-Dichlor-1,1,2,2,3-pentafluorpropan (R225cb) bzw. ein Gemisch dieser beiden Dichlorpentafluorpropane ist. Aber auch Zusammensetzungen mit anderen Isomeren insbesondere von Dichlortrifluorethan oder Dichlormonofluorethan, also 1,2-Dichlor-1,1,2-trifluorethan (R123a), 1,1-Dichlor-1,2,2-trifluorethan (R123b), 1,2-Dichlor-1-fluorethan (R141) und 1,1-Dichlor-2-fluorethan (R141a), sind sehr gut geeignet. Weitere vorteilhafte Zusammensetzungen sind jene, in denen als wasserstoffhaltiger Fluorchlorkohlen wasserstoff das 1,1,2,2-Tetrachlor-2-fluorethan (R121) oder das 1,1,2-Trichlor-2,2-difluorethan (R122) enthalten ist.

Teilweise fluorierte Alkanole im Sinne der Erfindung sind Alkanole, die außer der OH-Gruppe und den zwei bis vier Kohlenstoffatomen. Wasserstoff und wenigstens ein Fluoratom enthalten. Die in den erfindungsgemäßen Zusammensetzungen enthaltenen, teilweise fluorierten Alkanole mit 2 bis 4 C-Atomen sind z.B. ausgewählt aus der Gruppe 2-Fluorethanol, 1,1-Difluorethanol-(2), 2,2,2-Trifluorethanol, 2-Fluorpropanol, 3-Fluorpropanol, 3,3-Difluorpropanol, 2,2-Difluorpropanol, 1,1-Difluorpropanol-(2), 3,3,3-Trifluorpropanol, 2,3,3,3-Tetrafluorpropanol, 2,2;3,3-Tetrafluorpropanol, 2,2,3,3,3-Pentafluorpropanol, 1,1,1,2,2-Pentafluorpropanol-(3), 4-Fluorbutanol und 4,4,4-Trifluorbutanol. Besonders bevorzugt sind Alkanole mit 2 bis 3 C-Atomen, insbesondere 2,2,2-Trifluorethanol (im folgenden kurz als Trifluorethanol bezeichnet), 2,2,3,3-Tetrafluorpropanol und insbesondere 2,2,3,3,3-Pentafluorpropanol.

In einer zweckmäßigen Ausgestaltung der Erfindung liegen binäre oder ternäre Zusammensetzungen aus einem oder zwei wasserstoffhaltigen Fluorchlorkohlenwasserstoff(en) und einem teilweise fluorierten Alkanol vor. Vorteilhaft sind binäre Zusammensetzungen aus 1,1-Dichlor-2,2,2-trifluorethan (R123) und 2,2,2-Trifluorethanol, 2,2,3,3-Tetrafluorpropanol oder 2,2,3,3,3-Pentafluorpropanol, wobei binäre Zusammensetzungen mit 2,2,3,3,3-Pentafluorpropanol besonders geeignet sind; binäre Zusammensetzungen aus 1,1-Dichlor-1-fluorethan (R141b) und 2,2,3,3,3-Pentafluorpropanol; und binäre Zusammensetzungen aus 1,1-Dichlor-2,2,3,3,3-pentafluorpropan (R225ca) oder 1,3-Dichlor-1,1,2,2,3-pentafluorpropan (R225cb) einerseits mit einem der Alkanole 2,2,3,3-Tetrafluorpropanol oder 2,2,3,3,3-Pentafluorpropanol andererseits, wobei das Isomere R225ca bevorzugt ist. Vorteilhafte ternäre zusammensetzungen enthalten 1,1-Dichlor-2,2,2-trifluorethan (R123), 1,1-Dichlor-1-fluorethan (R141b) und 2,2,3,3,3-Pentafluorpropanol, andere vorteilhafte ternäre Zusammensetzungen sind Gemische der Isomere R225ca und R225cb mit einem der Alkanole 2,2,3,3-Tetrafluorpropanol oder 2,2,3,3,3-Pentafluorpropanol.

In besonders vorteilhaften Varianten von binären und ternären Zusammensetzungen der Erfindung zeichnen sich diese durch ein azeotropartiges bzw. azeotropes Verhalten aus. Solche azeotropen bzw. azeotropartigen Zusammensetzungen von Lösungsmitteln weisen eine Reihe von anwendungstechnischen Vorteilen auf. Einerseits sieden sie konstant bzw. im wesentlichen konstant und andererseits bleibt dabei auch die Zusammensetzung der Gemische konstant bzw. im wesentlichen konstant. Bei Verwendung azeotroper bzw. azeotropartiger Zusammensetzungen kommt es somit nicht zur Fraktionierung der Lösungsmittelbestandteile der Zusammensetzungen, wodurch unerwünschte Eigenschaftsveränderungen, wie z.B. verminderte Lösekraft, verminderte Inertheit gegenüber den zu reinigenden Gegenständen oder erhöhte Entflammbarkeit bei Verwendung entzündlicher Colösungsmittel, vermieden werden. Darüber hinaus lassen sich azeotrope bzw. azeotropartige Zusammensetzungen nach Gebrauch leicht durch gewöhnliche Destillation reinigen und stehen somit in einfacher Weise für die Wiederverwendung zur Verfügung, ohne daß die Charakteristika der ursprünglichen Zusammensetzung verloren gehen. Bedauerlicherweise ist es jedoch nicht möglich, die Bildung von azeotropen oder azeotropartigen Zusammensetzungen vorauszusagen, wodurch die Suche nach neuen azeotropen bzrn. azeotropartigen Lösungsmittelsystemen erschwert wird.

Erfindungsgemäß wurde nun gefunden, daß einige binäre Zusammensetzungen aus 1,1-Dichlor-2,2,2-

3

EP 0 427 069 A2

trifluorethan (R123) bzw. 1,1-Dichlor-1-fluorethan (R141b) einerseits und 2,2,3,3,3-Pentafluorpropanol andererseits sehr enge Siedebereiche aufweisen und sich somit azeotropartig verhalten. Eine Gruppe dieser
speziellen azeotropartigen Zusammensetzungen enthält 98,5 bis 96,5 Gew.-% 1,1-Dichlor-2,2,2-trifluorethan
(R123) im Gemisch mit 1,5 bis 3,5 Gew.-% 2,2,3,3,3-Pentafluorpropanol, wobei diese Zusammensetzungen
in einem Bereich von 27 bis 30 °C sieden (Atmosphärendruck). Besonders günstig ist hierbei die azeotrope
Zusammensetzung mit etwa 97,4 Gew.-% 1,1-Dichlor-2,2,2-trifluorethan (R123) und 2,6 Gew.-% 2,2,3,3,3-
Pentafluorpropanol, die einen Siedepunkt von etwa 27,2 °C bei Atmosphärendruck aufweist. Eine andere
Gruppe dieser speziellen azeotropartigen Zusammensetzungen enthält 96,0 bis 94,0 Gew.-% 1,1-Dichlor-1-
fluorethan (R141b) im Gemisch mit 4,0 bis 6,0 Gew.-% 2,2,3,3,3-Pentafluorpropanol, wobei diese Zusammensetzungen in einem Bereich von 33 bis 37 °C sieden (Atmosphärendruck). Besonders günstig ist
hierbei die azeotrope Zusammensetzung mit etwa 94,9 Gew.-% 1,1-Dichlor-1-fluorethan (R141b) und 5,1
Gew.-% 2,2,3,3,3-Pentafluorpropanol, die einen Siedepunkt von etwa 32,8 °C bei Atmosphärendruck
aufweist.

Erfindungsgemäß wurde weiterhin gefunden, daß auch einige ternäre Zusammensetzungen aus 1,1-
Dichlor-2,2,2-trifluorethan (R123), 1,1-Dichlor-1-fluorethan (R141b) und 2,2,3,3,3-Pentafluorpropanol sehr
enge Siedebereiche aufweisen und sich somit ebenfalls azeotropartig verhalten. Eine Gruppe dieser
speziellen ternären azeotropartigen Zusammensetzungen enthält 44,0 bis 49,0 Gew.-% 1,1-Dichlor-2,2,2-
trifluorethan (R123), 53,0 bis 46,0 Gew.-% 1,1-Dichlor-1-fluorethan (R141b) und 3,0 bis 5,0 Gew.-%
2,2,3,3,3-Pentafluorpropanol, wobei diese Zusammensetzungen in einem Bereich von 30 bis 33 °C sieden
(Atmosphärendruck). Besonders günstig ist hierbei die azeotrope Zusammensetzung mit etwa 46,4 Gew.-%
1,1-Dichlor-2,2,2-trifluorethan (R123), 49,7 Gew.-% 1,1-Dichlor-1-fluorethan (R141b) und 3,9 Gew.-%
2,2,3,3,3-Pentafluorpropanol, die einen Siedepunkt von etwa 30,3 °C bei Atmosphärendruck aufweist.

Erfindungsgemäß wurde darüber hinaus gefunden, daß einige binäre Zusammensetzungen aus 1,1-
Dichlor-2,2,3,3,3-pentafluorpropan (R225ca) einerseits und 2,2,3,3-Tetrafluorpropanol bzw. 2,2,3,3,3-Pentafluorpropanol andererseits sehr enge Siedebereiche aufweisen und sich somit azeotropartig verhalten. Eine
Gruppe dieser speziellen azeotropartigen Zusammensetzungen enthält 93,0 bis 90,0 Gew.-% 1,1-Dichlor-
2,2,3,3,3-pentafluorpropan (R225ca) im Gemisch mit 7,0 bis 10,0 Gew.-% 2,2,3,3,3-Pentafluorpropanol,
wobei diese Zusammensetzungen in einem Bereich von 48,5 bis 52 °C sieden (Atmosphärendruck).
Besonders günstig ist hierbei die azeotrope Zusammensetzung mit etwa 91,5 Gew.-% 1,1-Dichlor-2,2,3,3,3-
pentafluorpropan (R225ca) und 8,5 Gew.-% 2,2,3,3,3-Pentafluorpropanol, die einen Siedepunkt von etwa
48,6 °C bei Atmosphärendruck aufweist. Eine andere Gruppe dieser speziellen azeotropartigen Zusammensetzungen enthält 98,0 bis 96,0 Gew.-% 1,1-Dichlor-2,2,3,3,3-pentafluorpropan (R225ca) im Gemisch mit 2,0
bis 4,0 Gew.-% 2,2,3,3-Tetrafluorpropanol, wobei diese Zusammensetzungen in einem Bereich von 49,5 bis
53 °C sieden (Atmosphärendruck). Besonders günstig ist hierbei die azeotrope Zusammensetzung mit etwa
97,1 Gew.-% 1,1-Dichlor-2,2,3,3,3-pentafluorpropan (R225ca) und 2:9 Gew.-% 2,2,3,3-Tetrafluorpropanol,
die einen Siedepunkt von etwa 49,6 °C bei Atmosphärendruck aufweist.

Es ist hierbei überraschend, daß die azeotropen bzw. azeotropartigen Zusammensetzungen trotz ihres
relativ geringen Alkanolgehaltes sehr gute Lösekraft besitzen und hervorragende Reinigungseigenschaften
aufweisen. Hierdurch sind sie für viele Anwendungszwecke besonders geeignet.

Die erfindungsgemäßen Zusammensetzungen sind bei Raumtemperatur klare Lösungen, denen an sich
bekannte Additive zugesetzt werden können (hierdurch wird das relative Verhältnis von wasserstoffhaltigem
Fluorchlorkohlenwasserstoff zu teilweise fluoriertem Alkanol, welches durch die obigen Gew.-%-Angaben
festgelegt ist, nicht verändert).

Eine Gruppe an sich bekannter Additive sind Stabilisatoren. Unter dieser Gruppe werden solche
Verbindungen zusammengefaßt, die eine unerwünschte Reaktion von Bestandteilen der Zusammensetzung
untereinander oder mit anderen Reaktionspartnern, wie beispielsweise Luftsauerstoff, Metall, Wasser usw.,
verhindern. Bekannte Stabilisatoren sind beispielsweise Nitroalkane, insbesondere Nitromethan, Nitroethan,
Alkylenoxide, insbesondere Butylenoxid, oder verzweigte Alkinole wie z.B. 2-Methylbutin-(3)-ol-(2). Diese
Stabilisatoren können allein oder miteinander in Kombination eingesetzt sein, wobei Mengen von 0,01 bis 5
Gew.-%, vorzugsweise von 0,05 bis 1 Gew.-%, bezogen auf das Gesamtgemisch gut geeignet sind.

Eine weitere Gruppe von Additiven umfaßt an sich bekannte Verbindungen aus der Gruppe der
Korrosionsinhibitoren, nichtionische oder ionische Emulgatoren, Farbstoffe etc.

Die obengenannten Zusammensetzungen haben zahlreiche Anwendungsmöglichkeiten auf dem Sektor
der Reinigung und/oder Dampfentfettung. Bei diesen an sich bekannten Verfahren wird der zu reinigende
Gegenstand in einer oder mehreren Stufen in flüssiges und/oder dampfförmiges Reinigungsgemisch
getaucht oder mit flüssigem Reinigungsgemisch besprüht. Die Reinigungswirkung kann in bekannten
Verfahren durch Anwendung bei Siedetemperatur und/oder Ultraschall und/oder Rühren gesteigert werden.
Ebenso ist eine Verbesserung der Reinigungswirkung durch mechanische Einwirkung, wie z.B. Bürsten,

4

EP 0 427 069 A2

bekannt.

Beispielsweise verwendet die elektronische Industrie für Lötverfahren vorherrschend organische Harzflußmittel, deren Überschüsse nach dem Lötvorgang von Leiterplatten entfernt werden müssen. Dieses erfolgt mit organischen Lösungsmitteln, die mit den Leiterplatten und den elektronischen Teilen verträglich sind, d.h. das Lösungsmittel darf nicht mit diesen reagieren. Die zu entfernenden Harzflußmittel sind Gemische polarer und nichtpolarer Verbindungen und enthalten oftmals zusätzlich spezielle Aktivatoren. Fluorierte wasserstoffhaltige Kohlenwasserstoffe allein, die nichtpolar sind, sind zur Entfernung der polaren Komponenten der Harze nicht wirksam. Auch sind sie nicht in der Lage, insbesondere spezielle hochaktivatorhaltige Flußmittel vollständig zu entfernen. Überraschenderweise können die erfindungsgemäßen Zusammensetzungen aus wasserstoffhaltigen Fluorchlorkohlenwasserstoffen und teilweise fluorierten Alkanolen sowohl die polaren als auch die nichtpolaren Komponenten entfernen und sind daher als Entfernungsmittel für Harzflußmittel, insbesondere für solche mit hohem Aktivatorgehalt, auf breiter Basis wirksam. Die erfindungsgemäßen Zusammensetzungen, insbesondere in den azeotropen und azeotropartigen Zusammensetzungen, sind für diese Anwendung besonders gut geeignet.

So lassen sich unbestückte und bestückte (insbesondere auch SMD-bestückte) Leiterplatten auch bei Verwendung von Flußmitteln mit hohem Aktivatoranteil problemlos mit den erfindungsgemäßen Zusammensetzungen reinigen, ohne daß es zu den bei Einsatz der üblichen Reinigungsmittel gefürchteten "weißen Belägen" kommt.

Die neuen Zusammensetzungen gemäß der Erfindung sind auch erwünschte Systeme für Kühl- und Schmiermittel, da die Zusammensetzungen eine niedrige Oberflächenspannung, eine niedrige Viskosität und zum größten Teil eine geeignet hohe Dichte besitzen. Die obigen physikalischen Eigenschaften sind jene, die für Schmiermittelanwendungen erwünscht sind. Beispielsweise sind die Zusammensetzungen nach der Erfindung erwünscht, wenn das Gemisch als ein Schmiermittel in metallverarbeitenden Maschinen verwendet wird, wie z.B. beim Bohren, Fräsen, Drehen, Gewindeschneiden, Stanzen oder dergleichen, wo eine rückstandsfreie Oberfläche erforderlich ist. Für diese Anwendungen können insbesondere auch an sich bekannte Schmiermitteladditive (wie z.B. in DE-OS 33 42 852 oder DE-OS 33 35 870 beschrieben) zugesetzt werden.

Die niedrige Oberflächenspannung, die hohe Benetzungsfähigkeit und die Dichte der Zusammensetzungen gemäß der Erfindung machen diese besonders geeignet zur Reinigung von Kapillarsystemen.

Die erfindungsgemäßen Zusammensetzungen können beispielsweise auch wie folgt eingesetzt werden;
- zur Reinigung von Kleinteilen bzw. Schüttgut (vorzugsweise in geschlossenen Anlagen),
- zum Strippen von Lack,
- als spezielles Lösungs-, Extraktions- und/oder Umkristallisationsmittel in der chemischen und pharmazeutischen Industrie.

Die erfindungsgemäßen Reinigungszusammensetzungen auf der Basis der nicht vollhalogenierten Fluorchlorkohlenwasserstoffe aus der Gruppe der Tetrachlormonofluorethane, der Trichlordifluorethane, der Dichlortrifluorethane, der Dichlormonofluorethane und Dichlorpentafluorpropane oder eines Gemisches aus diesen wasserstoffhaltigen Fluorchlorkohlenwasserstoffen, die als Colösungsmittel ein teilweise fluoriertes Alkanol mit 2 bis 4 6-Atomen enthalten, gewährleisten in hohem Maße den hohen Reinheitsgrad, der in speziellen Einsatzgebieten, z.B. bei der Reinigung von Bauteilen und Leiterplatten in der elektronischen Industrie, erforderlich ist. In ihren Eigenschaften stehen sie den bisher im Stand der Technik bekannten Zusammensetzungen aus vollhalogenierten Fluorchlorkohlenwasserstoffen, nichtfluorierten oder teilweise fluorierten Alkanolen und gegebenenfalls weiteren polaren Zusätzen wie z.B. Methylacetat nicht nach. Es überrascht hierbei um so mehr, daß die neuen erfindungsgemäßen Zusammensetzungen im Gegensatz zu vielen Gemischen des Standes der Technik auch ohne weitere polare Zusätze zur Erhöhung der Lösekraft hervorragende Reinigungseigenschaften zeigen und für die genannten Anwendungen sehr gut geeignet sind. Ein weiterer Vorteil der erfindungsgemäßen Zusammensetzungen besteht darin, daß diese erhöhte und im Falle der Azeotrope mit 2,2,3,3-Pentafluorpropanol bzw. 2,2,3,3-Tetrafluorpropanol sogar keine Flammpunkte aufweisen. Durch die erfindungsgemäßen Zusammensetzungen werden daher auf einem breiten Anwendungsgebiet neue Problemlösungen ermöglicht. Darüber hinaus erweist es sich auch als vorteilhaft, daß die eingesetzten, nicht vollhalogenierten Fluorchlorkohlenwasserstoff-Lösungsmittel gegenüber vollhalogenierten fluorchlorkohlenwasserstoffen leichtere Abbaubarkeit und somit deutlich erhöhte Umweltverträglichkeit zeigen.

Die folgenden Beispiele sollen die Erfindung näher erläutern, ohne sie jedoch in ihrem Umfang zu begrenzen. Sofern nicht anders angegeben, sind % immer Gew.-%.


Beispiel 1; Reinigung von Leiterplatten

In einer handelsüblichen 2- bzw. 3-Kammer-Reinigungsanlage wurden Reinigungsversuche mit Leiterplatten, die sornohl mit üblichen halogenhaltigen Lötflußmitteln als auch mit stark aktivatorhaltigen Lötflußmitteln verunreinigt waren, vorgenommen. Sowohl die Verunreinigungen durch übliche halogenhaltige als auch durch stark aktivatorhaltige Lötflußmittel konnten von den Leiterplatten mit hervorragenden Reinigungsergebnissen entfernt werden. Die Reinigungszusammensetzungen, Reinigungsbedingungen und Reinigungsergebnisse sind in der Tabelle 1 wiedergegeben. Hierin stehen die Bezeichnungen "Trifluorethanol" für 2,2,2-Trifluorethanol, "Tetrafluorpropanol" für 2,2,3,3-Tetrafluorpropanol und "Pentafluorpropanol" für 2,2,3,3,3-Pentafluorpropanol.

Tabelle 1:

| Nr. | Zusammensetzungen für Bad 1 | Reinigungsbedingungen | Ergebnis |
|-----|------------------------------|------------------------|----------|
| 1 | R123/Trifluor-ethanol: 80,0 % / 20,0 % | 3-Bad: <br> 1) 3 Min. Ultraschall <br> 2) 1 Min. Ultraschall <br> 3) 1 Min. Dampfentfettung <br> (im Bad 2 und 3: R123) | ++ |
| 2 | R123/Tetrafluor-propanol: 65,0 % / 35,0 % | 3-Bad: <br> 1) 3 Min. Ultraschall <br> 2) 1 Min. Ultraschall <br> 3) 1 Min. Dampfentfettung <br> (im Bad 2 und 3: R123) | ++ |
| 3 | R123/Pentafluor-propanol: 98,5 % / 1,5 % | 2-Bad: <br> 1) 3 Min. Ultraschall <br> 2) 1 Min. Dampfentfettung <br> (Zusammensetzung im Bad 2 wie Bad 1) | ++ |

7

| Nr. | Zusammensetzungen für Bad 1 | Reinigungsbedingungen | Ergebnis |
|---|---|---|---|
| 4 | R123/Pentafluor-propanol: 97,4 % / 2,6 % | 2-Bad: 1) 3 Min. Ultra-schall 2) 1 Min. Dampf-entfettung (Zusammensetzung im Bad 2 wie Bad 1) | ++ |
| 5 | R123/Pentafluor-propanol: 50,0 % / 50,0 % | 3-Bad: 1) 3 Min. Ultra-schall 2) 1 Min. Ultra-schall 3) 1 Min. Dampf-entfettung (im Bad 2 und 3: R123) | ++ |
| 6 | R141b/Pentafluor-propanol: 65,0 % / 35,0 % | 3-Bad: 1) 3 Min. Ultra-schall 2) 1 Min. Ultra-schall 3) 1 Min. Dampf-entfettung (im Bad 2 und 3: R141b) | ++ |

| Nr. | Zusammensetzungen für Bad 1 | Reinigungsbedingungen | Ergebnis |
|---|---|---|---|
| 7 | R141b/Pentafluor-propanol 96,0 % / 4,0 % | 2-Bad: <br> 1) 3 Min. Ultra-schall <br> 2) 1 Min. Dampf-entfettung (Zusammensetzung im Bad 2 wie Bad 1) | ++ |
| 8 | R141b/Pentafluor-propanol: 94,9 % / 5,1 % | 2-Bad: <br> 1) 3 Min. Ultra-schall <br> 2) 1 Min. Dampf-entfettung (Zusammensetzung im Bad 2 wie Bad 1) | ++ |
| 9 | R141b/R123/Penta-fluorpropanol: 53,0 % / 44,0 % / 3,0 % | 3-Bad: <br> 1) 3 Min. Ultra-schall <br> 2) 1 Min. Ultra-schall <br> 3) 1 Min. Dampf-entfettung (im Bad 2 und 3: R123) | ++ |

| Nr. | Zusammensetzungen für Bad 1 | Reinigungsbedin- gungen | Ergebnis |
|---|---|---|---|
| 10 | R141b/R123/Penta- fluorpropanol: 49,7 % / 46,4 % / 3,9 % | 2-Bad: 1) 3 Min. Ultra- schall 2) 1 Min. Dampf- entfettung (Zusammensetzung im Bad 2 wie Bad 1) | ++ |

In den in der Spalte "Ergebnis" mit "+ +" gekennzeichneten Fällen ist eine sehr gute Reinigungswirkung erzielt worden und es kam nicht zur Bildung "weißer Beläge". Es ist deutlich sichtbar, daß die erfindungsgemäßen Zusammensetzungen hervorragende Reinigungsleistungen zeigen.

Beispiel 2: Reinigung von Leiterplatten, Glaslinsen und Aluminiumplatten

In einer handelsüblichen 2-Kammer-Reinigungsanlage wurden Reinigungsversuche mit Leiterplatten, die sowohl mit üblichen halogenhaltigen Lötflußmitteln als auch mit stark aktivatorhaltigen Lötflußmitteln verunreinigt waren, vorgenommen. Sowohl die Verunreinigungen durch übliche halogenhaltige als auch durch stark aktivatorhaltige Lötflußmittel konnten von den Leiterplatten mit hervorragenden Reinigungsergebnissen entfernt werden. Ferner wurden mit Öl und/oder Fett verunreinigte Glaslinsen und Aluminiumplatten gereinigt. Die Reinigungszusammensetzungen, Reinigungsbedingungen und Reinigungsergebnisse sind in der Tabelle 2 wiedergegeben. Hierin stehen die Bezeichnungen "Tetrafluorpropanol" für 2,2,3,3-Tetrafluorpropanol und "Pentafluorpropanol" für 2,2,3,3,3-Pentafluorpropanol.

Tabelle 2

| Nr. | Zusammensetzungen für Bad 1 und 2 | Reinigungsbedingungen | Material | Ergebnis |
|---|---|---|---|---|
| 1 | R225ca/Tetrafluorpropanol: 97,1 % / 2,9 % | 2-Bad: | a) Leiterplatten | + + |
| | | 1) 3 Min. Ultraschall | b) Glaslinsen | + + |
| | | 2) 1 Min. Dampfentfettung | c) Aluminiumplatten | + + |
| 2 | R225ca/Pentafluorpropanol: 91,5 % / 8,5 % | 2-Bad: | a) Leiterplatten | + + |
| | | 1) 3 Min. Ultraschall | b) Glaslinsen | + + |
| | | 2) 1.Min. Dampfentfettung | c) Aluminiumplatten | + + |

In den in der Spalte "Ergebnis" mit "+ +" gekennzeichneten Fällen ist eine sehr gute Reinigungswirkung erzielt worden und es kam nicht zur Bildung "weißer Beläge". Im Falle der Reinigung von Glaslinsen und Aluminiumplatten waren diese nach der Reinigung völlig frei von Öl bzrn. Fett. Es ist deutlich sichtbar. daß die erfindungsgemäßen Zusammensetzungen hervorragende Reinigungsleistungen zeigen.

Beispiel 3: Reinigung von Schüttgut

10

a) Schüttgut (Transistoren-Kappen) wurde zur Entfernung von Ziehölen in einer 2-Kammer-Anlage (3 Minuten Ultraschall, 1 Minute Dampfentfettung) mit einer azeotropen Zusammensetzung aus 97,4 % R123 und 2,6 % 2,2,3,3,3-Pentafluorpropanol gereinigt. Nach Behandlung war das Schüttgut einwandfrei saüber.

Analog zu a) wurde Schüttgut mit azeotropen Zusammensetzungen aus

b) 94,9 % R141b und 5,1 % 2,2,3,3,3-Pentafluorpropanol, bzw. aus

c) 49,7 % R141b, 46,4 % R123 und 3,9 % 2,2,3,3,3-Pentafluorpropanol,

d) 97,1 % R225ca und 2,9 % 2,2,3,3-Tetrafluorpropanol,

e) 91,5 % R225ca und 8,5 % 2,2,3,3,3-Pentafluorpropanol gereinigt. Nach der Behandlung war das Schüttgut in den Fällen b) bis e) ebenfalls einwandfrei saüber,

## Ansprüche

1. Zusammensetzungen, gekennzeichnet durch einen Gehalt an 99,5 bis 50,0 Gew.-% eines wasserstoffhaltigen Fluorchlorkohlenwasserstoffes mit 2 bis 3 C-Atomen aus der Gruppe der Tetrachlormonofluorethane, der Trichlordifluorethane, der Dichlortrifluorethane, der Dichlormonofluorethane und Dichlorpentafluorpropane oder eines Gemisches aus diesen wasserstoffhaltigen Fluorchlorkohlenwasserstoffen, vorzugsweise aus der Gruppe der Dichlortrifluorethane, Dichlormonofluorethane und Dichlorpentafluorpropane oder deren Gemische, und 0,5 bis 50,0 Gew.-% eines teilweise fluorierten Alkanols mit 2 bis 4 C-Atomen oder eines Gemisches dieser teilweise fluorierten Alkanole, wobei die Summe der Bestandteile 100 Gew.-% ist.

2.- Zusammensetzungen nach Anspruch 1, dadurch gekennzeichnet, daß der wasserstoffhaltige Fluorchlorkohlenwasserstoff 1,1,2,2-Tetrachlor-2-fluorethan (R121), 1,1,2-Trichlor-2,2-difluorethan (R122), 1,1-Dichlor-2,2,2-trifluorethan (R123), 1,1-Dichlor-1-fluorethan (R141b), 1,1-Dichlor-2,2,3,3,3-pentafluorpropan (R225ca) oder 1,3-Dichlor-1,1,2,2,3-pentafluorpropan (R225cb), vorzugsweise 1,1-Dichlor-2,2,2-trifluorethan (R123), 1,1-Dichlor-1-fluorethan (R141b), 1,1-Dichlor-2,2,3,3,3-pentafluorpropan (R225ca) oder 1,3-Dichlor-1,1,2,2,3-pentafluorpropan (R225cb), ist.

3. Zusammensetzungen nach einem der vorhergehenden Ansprüche, dadurch gekennzeichnet, daß das teilweise fluorierte Alkanol ein Alkanol mit 2 bis 3 C-Atomen, vorzugsweise 2,2,2-Trifluorethanol, 2,2,3,3-Tetrafluorpropanol oder 2,2,3,3,3-Pentafluorpropanol, ist.

4. Zusammensetzungen nach einem der vorhergehenden Ansprüche, gekennzeichnet durch eine binäre Zusammensetzung aus 1,1-Dichlor-2,2,2-trifluorethan (R123) und 2,2,2-Trifluorethanol, 2,2,3,3-Tetrafluorpropanol oder 2,2,3,3,3-Pentafluorpropanol, vorzugsweise 2,2,3,3,3-Pentafluorpropanol.

5. Zusammensetzungen nach Anspruch 4, gekennzeichnet durch eine azeotropartige Zusammensetzung von 98,5 bis 96,5 Gew.-% 1,1-Dichlor-2,2,2-trifluorethan (R123) und 1,5 bis 3,5 Gew.-% 2,2,3,3,3-Pentafluorpropanol, wobei die Summe der Bestandteile 100 Gew.-% ist.

6. Zusammensetzung nach Anspruch 5, gekennzeichnet durch eine azeotrope Zusammensetzung von annähernd 97,4 Gew.-% 1,1-Dichlor-2,2,2-trifluorethan (R123) und 2,6 Gew.-% 2,2,3,3,3-Pentafluorpropanol mit einem Siedepunkt von etwa 27,2 °C bei Atmosphärendruck.

7. Zusammensetzungen nach einem der Ansprüche 1 bis 3, gekennzeichnet durch eine binäre Zusammensetzung aus 1,1-Dichlor-1-fluorethan (R141b) und 2,2,3,3,3-Pentafluorpropanol.

8. Zusammensetzung nach Anspruch 7, gekennzeichnet durch eine azeotropartige Zusammensetzung von 96,0 bis 94,0 Gew.-% 1,1-Dichlor-1-fluorethan (R141b) und 4,0 bis 6,0 Gew.-% 2,2,3,3,3-Pentafluorpropanol, wobei die Summe der Bestandteile 100 Gew.-% ist.

9. Zusammensetzung nach Anspruch 8, gekennzeichnet durch eine azeotrope Zusammensetzung von annähernd 94,9 Gew.-% 1,1-Dichlor-1-fluorethan (R141b) und 5,1 Gew.-% 2,2,3,3,3-Pentafluorpropanol mit einem Siedepunkt von etwa 32,8 °C bei Atmosphärendruck.

10. Zusammensetzungen nach einem der Ansprüche 1 bis 3, gekennzeichnet durch eine ternäre Zusammensetzung von 1,1-Dichlor-2,2,2-trifluorethan (R123), 1,1-Dichlor-1-fluorethan (R141b) und 2,2,3,3,3-Pentafluorpropanol.

11. Zusammensetzungen nach Anspruch 10, gekennzeichnet durch eine azeotropartige Zusammensetzung von 44,0 bis 49,0 Gew.-% 1,1-Dichlor-2,2,2-trifluorethan (R123), 53,0 bis 46,0 Gew.-% 1,1-Dichlor-1-fluorethan (R141b) und 3,0 bis 5,0 Gew.-% 2,2,3,3,3-Pentafluorpropanol, wobei die Summe der Bestandteile 100 Gew.-% ist.

12. Zusammensetzung nach Anspruch 11, gekennzeichnet durch eine azeotrope Zusammensetzung von annähernd 46,4 Gew.-% 1,1-Dichlor-2,2,2-trifluorethan (R123), 49,7 Gew.-% 1,1-Dichlor-1-fluorethan (R141b) und 3,9 Gew.-% 2,2,3,3,3-Pentafluorpropanol mit einem Siedepunkt von etwa 30,3 °C bei Atmosphärendruck.

13. Zusammensetzungen nach einem der Ansprüche 1 bis 3, gekennzeichnet durch eine Zusammenset-

11

zung aus 1,1-Dichlor-2,2,3,3,3-pentafluorpropan (R225ca) und/oder 1,3-Dichlor-1,1,2,2,3-pentafluorpropan (R225cb) einerseits und einem der Alkanole 2,2,3,3-Tetrafluorpropanol oder 2,2,3,3,3-Pentafluorpropanol andererseits.

14. Zusammensetzungen nach Anspruch 13, gekennzeichnet durch eine azeotropartige Zusammensetzung von 93,0 bis 90,0 Gew.-% 1,1-Dichlor-2,2,3,3,3-pentafluorpropan (R225ca) und 7,0 bis 10,0 Gew.-% 2,2,3,3,3-Pentafluorpropanol, wobei die Summe der Bestandteile 100 Gew.-% ist.

15. Zusammensetzung nach Anspruch 14, gekennzeichnet durch eine azeotrope Zusammensetzung von annähernd 91,5 Gew.-% 1,1-Dichlor-2,2,3,3,3-pentafluorpropan (R225ca) und 8,5 Gew.-% 2,2,3,3,3-Pentafluorpropanol mit einem Siedepunkt von etwa 48,6 °C bei Atmosphärendruck.

16. Zusammensetzung nach Anspruch 13, gekennzeichnet durch eine azeotropartige Zusammensetzung von 98,0 bis 96,0 Gew.-% 1,1-Dichlor-2,2,3,3,3-pentafluorpropan (R225ca) und 2,0 bis 4,0 Gew.-% 2,2,3,3-Tetrafluorpropanol, wobei die Summe der Bestandteile 100 Gew.-% ist.

17. Zusammensetzung nach Anspruch 16, gekennzeichnet durch eine azeotrope Zusammensetzung von annähernd 97,1 Gew.-% 1,1-Dichlor-2,2,3,3,3-pentafluorpropan (R225ca) und 2,9 Gew.-% 2,2,3,3-Tetrafluorpropanol mit einem Siedepunkt von etwa 49,6 °C bei Atmosphärendruck.

18. Zusammensetzungen gemäß einem der vorhergehenden Ansprüche, gekennzeichnet durch einen zusätzlichen Gehalt an Stabilisator von 0,01 bis 5 Gew.-%, vorzugsweise 0,05 bis 1 Gew.-% bezogen auf das Gesamtgemisch, vorzugsweise aus der Gruppe Nitroalkan, Alkylenoxid und/oder Alkinol.

19. Verwendung der Zusammensetzungen gemäß einem der vorhergehenden Ansprüche in Tauch- und/oder Sprüh-Reinigungsverfahren oder bei der Dampfentfettung.

20. Verfahren zum Reinigen von Oberflächen, dadurch gekennzeichnet, daß man die Oberflächen mit Zusammensetzungen nach einem der Ansprüche 1 bis 18 behandelt.

21. Verfahren nach Anspruch 20, dadurch gekennzeichnet, daß die zu reinigenden Oberflächen mit Lötflußmittel oder Lötflußmittelrückständen verunreinigte gedruckte Leiterplatten sind.